# EUROPEAN PATENT APPLICATION

(11) **EP 4 400 447 A1**
(43) Date of publication of application: **17.07.2024**
(21) Application number: 22867009.7
(22) Date of filing: 09.06.2022
(51) Int. Cl.: B65D 83/06, H05K 13/02

(54) **CASE**

(30) Priority: 08.09.2021 JP 2021146423
(71) Applicant: Murata Manufacturing Co., Ltd., Nagaokakyo-shi, Kyoto 617-8555 (JP)
(72) Inventor: NAKAGAWA, Kiyoyuki, Nagaokakyo-shi Kyoto 617-8555 (JP); SHIMIZU, Yasuhiro, Nagaokakyo-shi, Kyoto 617-8555 (JP)
(74) Representative: Stöckeler, Ferdinand
(86) International application number: PCT/JP2022/023324
(87) International publication number: WO 2023/037679

(57) **Abstract**

Provided is a case that facilitates peeling off of an attached label therefrom. A case includes a case body 10 including an accommodation space 11 that accommodates a plurality of electronic components M and a discharge portion 19 that accommodates in and discharges the plurality of electronic components M and from the accommodation space 11. A label 70 is attachable to the case body 10. A shutter member 30 that is slidably provided to the case body 10 and opens and closes the discharge port 19 by sliding. The case body 10 includes, on at least a portion on a surface 2a thereof, a label attaching region 90 including a plurality of protruding portions 93 to which an attaching surface 70a of the label 70 is attachable.

## Description

### BACKGROUND OF THE INVENTION

### Field of the Invention

The present invention relates to a case for accommodating electronic components such as chip components.

### Related Art

When mounting electronic components on a board, a mounting device is used which mounts each of the electronic components at a predetermined position on the board. It is necessary to supply electronic components individually to such a mounting device. For example, Japanese Unexamined Patent Application, Publication No. 2009-295618 discloses a case in which electronic components in a loose state are collectively housed, and the electronic components are dropped onto a feeder by their own weight from a take-out port at a bottom portion. The electronic components are individually supplied to the mounting device by the feeder.

Patent Document 1: Japanese Unexamined Patent Application, Publication No. 2009-295618

### SUMMARY OF THE INVENTION

In such a case, the electronic components are sometimes managed by attaching a label indicating the type of the electronic components accommodated therein to the case. However, when such a case is repeatedly used or reproduction processed for recycling, the attached label may become an obstacle.

Embodiments of the present invention provide a case that facilitates peeling off of an attached label therefrom.

Embodiments of the present invention provide a case including a case body including an accommodation space that accommodates a plurality of components and an opening that accommodates in and discharges the plurality of components from the accommodation space, in which a label is attachable to the case body; and a shutter member that is slidably provided to the case body and opens and closes the opening by sliding, in which the case body includes, on at least a portion on a surface thereof, a label attaching region including a plurality of protruding portions to which an attaching surface of the label is attachable.

According to embodiments of the present invention, it is possible to provide a case that facilitates peeling off of an attached label therefrom.

### BRIEF DESCRIPTION OF THE DRAWINGS

FIG. 1 is a perspective view of a case according to an embodiment of the present invention as viewed from below.
FIG. 2 is a front view of the case according to the embodiment.
FIG. 3 is a bottom view of the case according to the embodiment.
FIG. 4 is a side view of an inside of the case according to the embodiment.
FIG. 5 is a side view of an inside of a front portion of the case according to the embodiment, and shows an open state in which a discharge port of the case is opened.
FIG. 6 is a diagram of a label according to the embodiment.
FIG. 7 is a side view of the case according to the embodiment in a state in which no label is attached.
FIG. 8 is a top view of the case according to the embodiment in a state in which no label is attached.
FIG. 9 is an enlarged view of a portion indicated by IX in FIG. 7.
FIG. 10 is a cross-sectional view taken along the line X-X of FIG. 9.
FIG. 11 is a plan view of a modified example of a recessed-protruding surface of the embodiment.
FIG. 12 is a cross-sectional view taken along the line XII-XII of FIG. 11 in a state where a label is attached.
FIG. 13 is a rear view of the case according to the embodiment.
FIG. 14 is an enlarged side view of a rear wall portion of the case according to the embodiment.

### DETAILED DESCRIPTION OF THE INVENTION

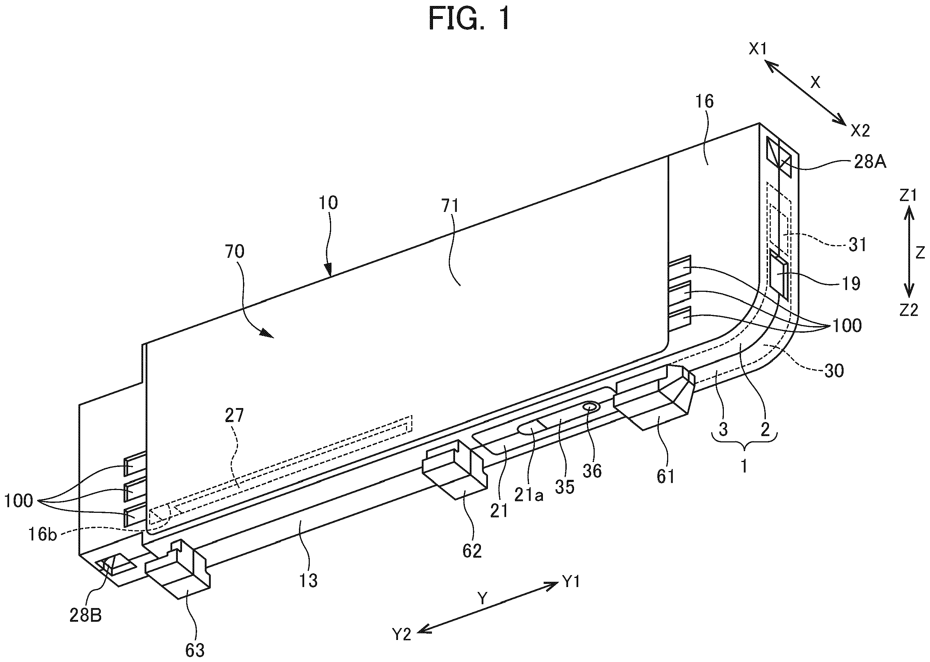

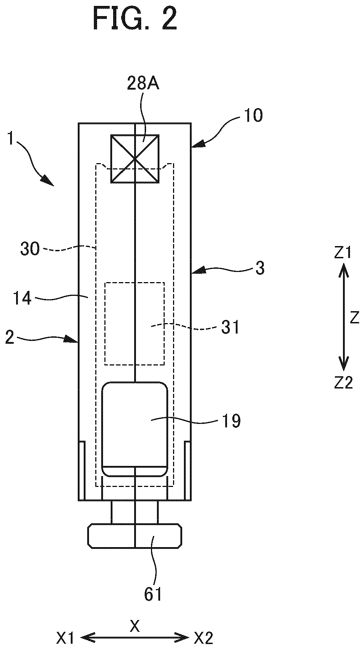

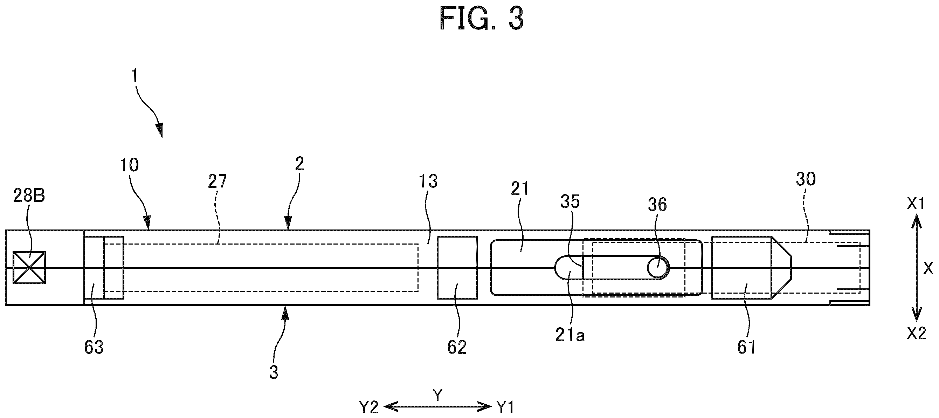

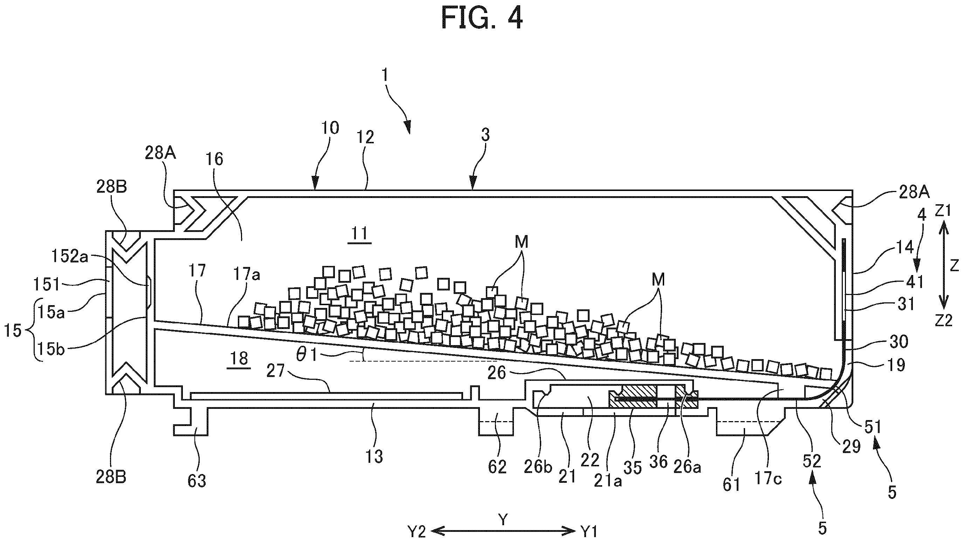

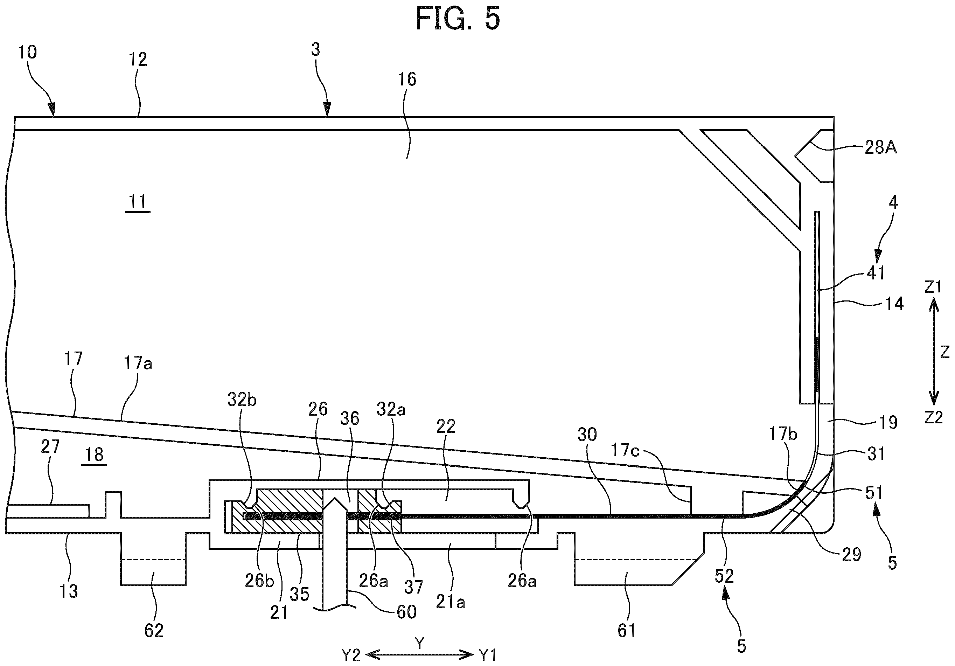

Embodiments of the present invention will be described with reference to the accompanying drawings. FIG. 1 is a perspective view of a case 1 according to an embodiment as viewed from below. FIG. 2 is a front view of the case 1. FIG. 3 is a bottom view of the case 1. FIG. 4 is a side view of the inside of the case 1. FIG. 5 is a side view of the inside of the front portion of the case 1.

As shown in FIG. 4, the case 1 accommodates therein a plurality of electronic components M as components in a loose state. The case 1 including the plurality of electronic components M is set in a feeder (not shown), and the electronic components M are discharged from the case 1 by vibration of the feeder and supplied to a mounting device or the like. Each of the electronic components M of the present embodiment is, for example, a minute rectangular parallelepiped electronic component having a length of 1.2 mm or less in the longitudinal direction. Examples of such electronic components include capacitors and inductors, but the present embodiment is not limited thereto.

Arrows X, Y, and Z in the reference drawings respectively indicate the left-right direction, the front-rear direction, and the up-down direction of the case 1 in the use state set in the feeder. Further, in the left-right direction X, the left side is denoted by X1 and the right side is denoted by X2; in the front-rear direction Y, the front side is denoted by Y1, the rear side is denoted by Y2; and in the up-down direction Z, the upper side is denoted by Z1, and the lower side is denoted by Z2. The left-right direction, the front-rear direction, and the up-down direction in the following description are based on the directions indicated by the arrows.

As shown in FIG. 1, the case 1 includes a first member 2 and a second member 3 which are divided into left and right. The first member 2 and the second member 3 are joined to each other to provide the case 1. The first member 2 and the second member 3 may be bonded by ultrasonic bonding or bonding using an adhesive, but are not limited thereto.

FIG. 4 shows a state in which the first member 2 on the left side is absent, and shows the inside of the second member 3 on the right side. The case 1 has a flat box shape that is long in the front-rear direction and thin in the left-right direction. In the following description, except where necessary, the first member 2 and the second member 3 are not individually described, and the configuration in which the first member 2 and the second member 3 are joined to each other will be described.

As shown in FIGS. 1 to 4, the case 1 includes a case body 10 that accommodates a plurality of electronic components M, a discharge port 19 that functions as an opening for accommodating the electronic components M in the case 1 and discharging the electronic components M from the case 1, a shutter member 30 that opens and closes the discharge port 19, and a slide member 35 that slides the shutter member 30.

As shown in FIG. 4, the case body 10 includes a top plate portion 12 and a bottom plate portion 13 which extend in the front-rear direction, a front wall portion 14 and a rear wall portion 15 which extend in the up-down direction, a pair of left and right side wall portions 16, and a sloped plate portion 17 which partitions the inside of the case body 10 vertically. The rear wall portion 15 includes an outer rear wall portion 15a defined and functioning as an outer surface and an inner rear wall portion 15b in front of the outer rear wall portion. An accommodation space 11 for accommodating the plurality of electronic components M in a loose state is provided inside the case body 10.

The discharge port 19 is provided at the lower portion of the front wall portion 14. The discharge port 19 is a rectangular opening. The discharge port 19 is not limited to a rectangular shape, and may be, for example, an opening having a circular shape, an elliptical shape, or the like. The discharge port 19 is opened and closed by a shutter member 30 described later.

The sloped plate portion 17 extends between the left and right side wall portions 16 and extends from the inner rear wall portion 15b to the lower portion of the discharge port 19. The sloped plate portion 17 is provided below the center of the case body 10 in the vertical direction. In the case body 10, the upper side of the sloped plate portion 17 serves as the accommodation space 11, and the lower side of the sloped plate portion 17 serves as a lower space 18.

The sloped plate portion 17 shown in FIF. 4 is sloped at a downward gradient toward the discharge port 19, and an upper surface of the sloped plate portion 17 is a sloped surface 17a which is sloped at a downward gradient toward the discharge port 19. In this embodiment, the slope angle θ1 of the sloped surface 17a is about 10° with respect to the horizontal direction when the case 1 is set to the feeder. The slope angle θ1 of the sloped surface 17a is preferably 3° or more and 10° or less. The slope angle θ1 of the sloped surface 17a is appropriately adjusted according to a vibration condition, etc. of the feeder described later.

As shown in FIG. 4, a band-shaped RFID tag 27 elongated in the front-rear direction is provided at a rear portion of the lower space 18. The RFID tag 27 is a sticker, for example, and is attached to the upper surface of the bottom plate portion 13. The RFID tag 27 is provided in the lower space 18 through a hole 16b provided in the side wall portion 16 shown in FIG. 1 and extending in the front-rear direction. The RFID tag 27 includes a known configuration including a transmission/reception unit, memory, an antenna, and the like. For example, a reader/writer that reads and writes information from and to the RFID tag 27 is provided in the feeder in which the case 1 is set.

The case body 10 includes upper grip portions 28A and rear grip portions 28B. The upper grip portions 28A are a pair of front and rear recesses provided at both front and rear ends of the upper side of the case body 10. The rear grip portions 28B are a pair of upper and lower recesses provided at both upper and lower ends of the rear side of the case body 10. Each of the upper grip portions 28A and the rear grip portions 28B is gripped by a robot hand, for example, when the case 1 is carried by the robot hand.

The case body 10 includes a plurality of claw portions on the bottom surface for detachably setting the case body 10 in the feeder. In the present embodiment, a first claw portion 61, a second claw portion 62, and a third claw portion 63 are provided on the bottom surface at intervals in the front-rear direction. The first claw portion 61, the second claw portion 62, and the third claw portion 63 are provided integrally with the case body 10. Each of the first claw portion 61 and the second claw portion 62 includes a T-shaped slot having an inverted T-shape in a cross section in a plane extending in the up, down, left, and right directions. The third claw portion 63 is an L-shaped plate piece extending rearward in a side view.

The shutter member 30 slides to open and close the discharge port 19. The shutter member 30 continuously extends from the bottom plate portion 13 to the front wall portion 14, and is slidable along the extending direction. The shutter member 30 is an elongated strip-shaped film member. The shutter member 30 is made of a bendable and flexible material having a certain degree of rigidity such as PET (Polyethylene terephthalate). The thickness of the shutter member 30 made of such a film-shaped member is not limited, but is preferably, for example, 0.1 mm or more and 0.5 mm or less. The width of the shutter member 30 is slightly larger than the width of the discharge port 19, and has a width capable of covering the discharge port 19 without any gap. An opening 31 having the same or substantially the same shape as the discharge port 19 is provided at the front end portion of the shutter member 30.

The shutter member 30 can slide along the lower guide portion 5 and the upper guide portion 4 of the case body 10. The lower guide portion 5 is provided above the bottom plate portion 13, and the upper guide portion 4 is provided above the discharge port 19. The rear side of the shutter member 30 slides substantially horizontally along the lower guide portion 5, and the front side of the shutter member 30 slides vertically along the upper guide portion 4. Each of the lower guide portion 5 and the upper guide portion 4 provides a passage for slidably holding the shutter member 30 while maintaining the surface direction of the shutter member 30 along the lateral direction.

As shown in FIGS. 4 and 5, the lower guide portion 5 includes a first lower guide portion 51 provided below the discharge port 19 and a second lower guide portion 52 provided behind the first lower guide portion 51. The second lower guide portion 52 is provided by a gap provided between the protruding portion 17c that projects downward at the front end portion of the sloped plate portion 17 and the bottom plate portion 13. The first lower guide portion 51 is provided by a front end surface 17b of the sloped plate portion 17 and a front end portion 29 of the bottom plate portion 13.

The rear portion of the shutter member 30 passes through the gap between the protruding portion 17c and the bottom plate portion 13 in the second lower guide portion 52. With such a configuration, the rear portion of the shutter member 30 slides in the front-rear direction immediately above the bottom plate portion 13. In the first lower guide portion 51, the shutter member 30 slides along the front end portion 29 of the bottom plate portion 13 which curves in a recessed manner in the front-rear direction, and further slides along the front end surface 17b of the sloped plate portion 17, such that the shutter member 30 bends upward at an angle of approximately 90° from the horizontal direction, and turns into a posture extending in the up-down direction.

As shown in FIGS. 4 and 5, the upper guide portion 4 includes a guide slit 41 provided in the front wall portion 14 and extending in the up-down direction. The front end portion of the shutter member 30 is provided in the guide slit 41 by insertion from the lower end of the front wall portion 14, and slides in the up-down direction in the guide slit 41.

The slide member 35 slides the shutter member 30 to open and close the discharge port 19. As shown in FIG. 4, a slide member 35 is provided at the rear end portion of the shutter member 30.

As shown in FIGS. 4 and 5, the bottom plate portion 13 of the case body 10 includes a protruding plate portion 21 on the front side thereof. The protruding plate portion 21 protrudes downward and extends in the front-rear direction. The protruding plate portion 21 is provided with a long hole 21a extending in the front-rear direction. A plate portion 26 is provided above the protruding plate portion 21 with a predetermined space 22 therebetween. The plate portion 26 is parallel or substantially parallel to the protruding plate portion 21, and is provided integrally with the bottom plate portion 13. The space 22 is surrounded by the protruding plate portion 21, the plate portion 26, and the left and right side wall portions 16. The slide member 35 is provided in the space 22. A front protruding portion 26a protruding downward is provided at a front end portion of the plate portion 26. A rear protruding portion 26b protruding downward is provided at a rear end portion of the plate portion 26.

The slide member 35 is a rectangular plate piece elongated in the front-rear direction. The slide member 35 includes a circular operation hole 36 penetrating in the up-down direction. The operation hole 36 communicates with the long hole 21a of the case body 10, and is exposed to the outside through the long hole 21a.

As shown in FIG. 5, a slit 37 extending in the front-rear direction and opening to the front side is provided in the middle of the slide member 35 in the up-down direction. The rear end portion of the shutter member 30 is provided in the slit 37 by insertion from the front opening. The slit 37 opens to the front side of the slide member 35, and does not open to the rear side. The slits 37 may open to the left and right sides of the slide member 35. The rear end portion of the shutter member 30 is provided in the slit 37 by insertion from a front end opening 37a of the slit 37. The shutter member 30 is fixed to the slide member 35 by means such as adhesion. With such a configuration, the shutter member 30 can slide in the space 22 integrally with the slide member 35. The shutter member 30 is guided by sliding by the protruding plate portion 21, the plate portion 26, and the left and right side wall portions 16 of the bottom plate portion 13, and slides in the front-rear direction.

As shown in FIG. 5, on the upper surface of the slide member 35, a front recess portion 32a is provided at the front end portion, and a rear recess portion 32b is provided at the rear end portion. When the slide member 35 slides forward, the front protruding portion 26a of the plate portion 26 enters the front recess portion 32a and engages therewith, and further forward sliding is restricted. At this time, the opening 31 of the shutter member 30 is provided above the discharge port 19, and the discharge port 19 is closed by a portion of the shutter member 30 below the opening 31.

On the other hand, when the slide member 35 slides rearward, as shown in FIG. 5, the rear protruding portion 26b of the plate portion 26 enters the rear recess portion 32b and engages therewith, and further rearward sliding is restricted. At this time, the opening 31 of the shutter member 30 coincides with the discharge port 19 to open the discharge port 19.

In the case 1, after a predetermined number of electronic components M are accommodated in the accommodation space 11 from the discharge port 19, the slide member 35 is slid forward to close the discharge port 19 with the shutter member 30, and the electronic components M are shipped to the supply destination of the electronic components. Therefore, FIG. 4 shows the inside of the case 1 at the time of shipment. The user who receives the supply of the case 1 can open the discharge port 19 as follows, for example.

As shown in FIG. 5, an operation pin 60 is inserted into the operation hole 36 of the slide member 35, and the shutter member 30 is pierced and penetrated by the operation pin 60. The operation pin 60 is moved rearward in the opening direction of the shutter member. With such a configuration, the shutter member 30 slides rearward in conjunction with the slide member 35, and the opening 31 of the shutter member 30 coincides with the discharge port 19 to open the discharge port 19.

The mechanism for sliding the shutter member 30 to open and close the discharge port 19 is not limited to the configuration in which the slide member 35 is provided integrally with the shutter member 30 as described above, and other mechanisms may be adopted.

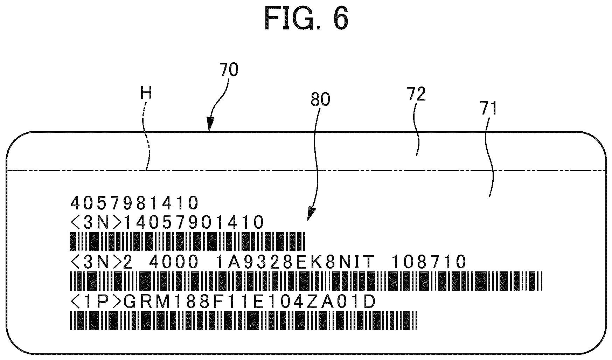

As shown in FIG. 1, in the case 1 of the embodiment, a label 70 is attached to the case body 10. FIG. 6 shows an example of the label 70 according to the embodiment. The label 70 is a label having a general structure in which an adhesive layer is provided on a paste surface on the rear surface side of a sheet-shaped base material made of resin, paper, or the like, and a release sheet is attached to the adhesive layer before being attached to the case body 10. Although the label 70 of the embodiment is rectangular, the shape of the label 70 is not limited thereto.

The label 70 includes a display label portion 71 on which the display 80 is printed, and an extra label portion 72 on the upper side of the display label portion 71. The chain double-dashed line H in FIG. 6 indicates a boundary between the display label portion 71 and the extra label portion 72.

A display 80 is printed on the surface of the display label portion 71. The display 80 shows information on the electronic components M accommodated in the case 1 and information on the case 1. Examples of the information on the electronic components M include a type of the electronic component M, a lot number, a manufacturing date, a manufacturing factory, and an inspection number. Examples of the information on the case 1 include a case number and the number of the electronic components M accommodated. The display 80 of the embodiment is a code by a combination of numerals and alphanumeric characters (alphabet) and a bar code, but the display 80 is not limited thereto. The display 80 may be only information about the electronic components M or may be only information about the case 1. Further, the display 80 may include a unique ID associated with both or one of the information relating to the electronic component M or the information relating to the case 1, and a URL associated therewith.

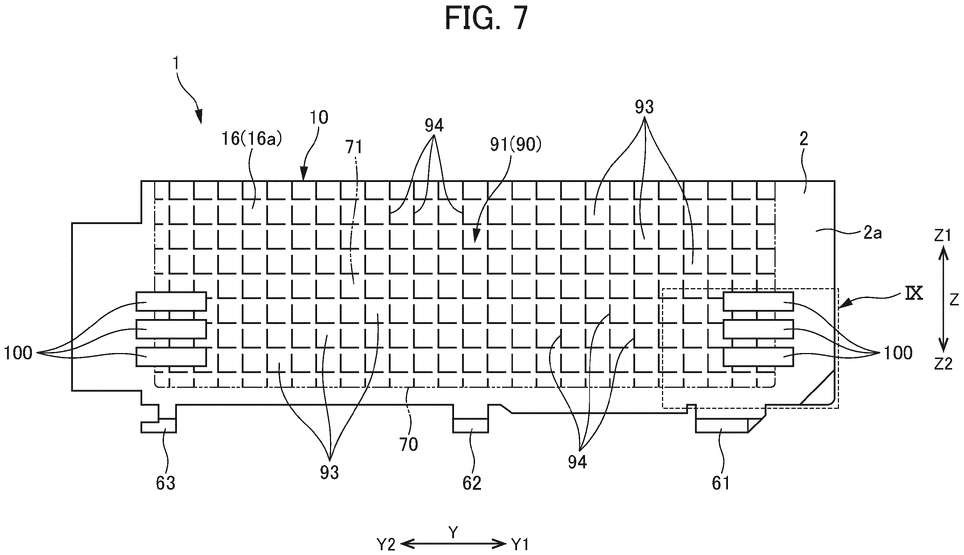

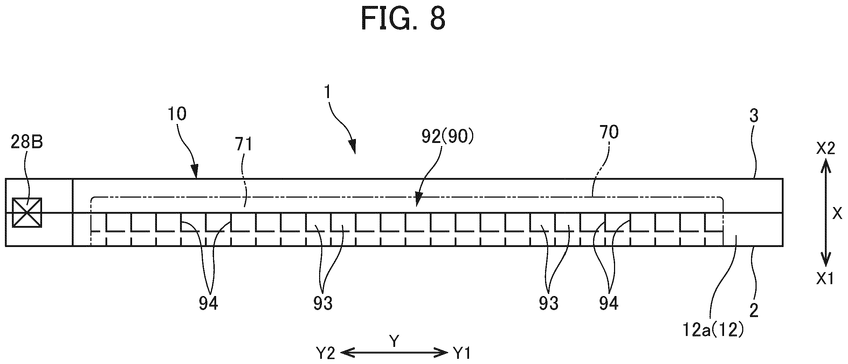

FIGS. 7 and 8 are respectively a side view and a top view of the first member 2 of the case 1 in a state in which the label 70 is not attached. On the surface 2a of the first member 2 of the case 1, a label attaching region 90 to which the label 70 is attached is defined. The surface 2a of the first member 2 includes a surface 16a of the side wall portion 16 and a surface 12a of the top plate portion 12. The label attaching region 90 is provided from the side wall portion 16 of the first member 2 over the top plate portion 12 of the first member 2. The label attaching region 90 includes a side surface region 91 provided on the side wall portion 16 and an upper surface region 92 provided on the top plate portion 12. The side surface region 91 occupies about 80% of the side wall portion 16, and the upper surface region 92 occupies about 80% of the top plate portion 12. A front end portion and a rear end portion of the side wall portion 16 and the top plate portion 12 include portions without the label attaching region 90.

The label 70 is attached to the label attaching region 90 such that the outer edge of the label 70 substantially coincides with the outer edge of the label attaching region 90. That is, the label attaching region 90 has a shape and a size corresponding to the label 70. The display label portion 71 of the label 70 is attached to the side surface region 91, and the extra label portion 72 is attached to the upper surface region 92 by bending the extra label portion 72 by approximately 90° toward the upper surface region 92.

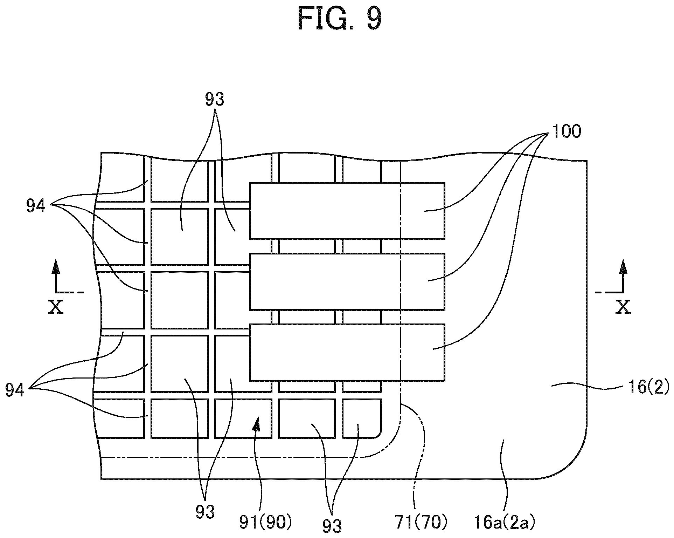

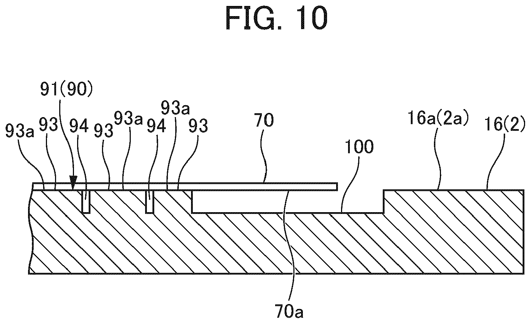

As shown in FIGS. 9 and 10, the label attaching region 90 includes a plurality of protruding portions 93 to which the attaching surface 70a of the label 70 is attached. The plurality of protruding portion 93 are provided therein in a distributed manner. Further, a plurality of recessed portions 94 spaced apart from the attaching surface 70a of the label 70 may be distributed. In other words, the region in which the plurality of protruding portions 93 or the plurality of recessed portions 94 are arranged is defined as the label attaching region 90.

Each of the plurality of protruding portions 93 has a rectangular shape. Each of the protruding portions 93 includes a flat surface 93a, and the height position of the flat surface 93a is the same as the height position of the surface 2a of the first member 2. Each of the plurality of recessed portions 94 is a straight groove-shaped recess and is continuously provided in a lattice shape. The protruding portion 93 is surrounded by the plurality of recessed portions 94 provided in a rectangular shape. Alternatively, the surface 93a of each of the protruding portions 93 may be flat, and the height position thereof may protrude from the height position of the surface 2a of the first member 2. At this time, the height of the plurality of recessed portions 94 provided around the protruding portions 93 is the same as the height position of the surface 2a, for example. Although FIGS. 9 and 10 show the side surface region 91, as shown in FIG. 8, the plurality of rectangular protruding portions 93 and the plurality of groove-shaped recessed portions 94 are similarly provided in the upper surface region 92.

In the surface of the label attaching region 90 in a plan view, it is preferable that the surface area occupied by the entirety of the plurality of protruding portions 93 is larger than the area occupied by the entirety of the plurality of recessed portions 94. Alternatively, it is preferable that the surface area of the entirety of the plurality of protruding portions 93 is larger than the area other than the area occupied by the plurality of protruding portions 93. For example, it is preferable that, in the label attaching region 90, the surface area of the entirety of the plurality of protruding portions 93 per unit area is preferably greater than 50% and equal to or less than 90%.

As shown in FIG. 7, the surface 16a of the side wall portion 16 having the side surface region 91 includes a plurality of groove-shaped depressions 100. Each of the depressions 100 includes a rectangular shape extending in the front-rear direction. For example, three depressions 100 are provided at each of the front end side and the rear end side of the side wall portion 16. Each depression 100 is provided from the side surface region 91 to the outside of the side surface region 91, i.e., over the surface 16a where the side surface region 91 is not provided. Each of the depressions 100 has a width and depth through which the tip of the finger or the tip of the nail can be inserted. The label 70 attached to the side surface region 91 is provided such that its edge traverses the middle portion of each the depressions 100 in the longitudinal direction, for example.

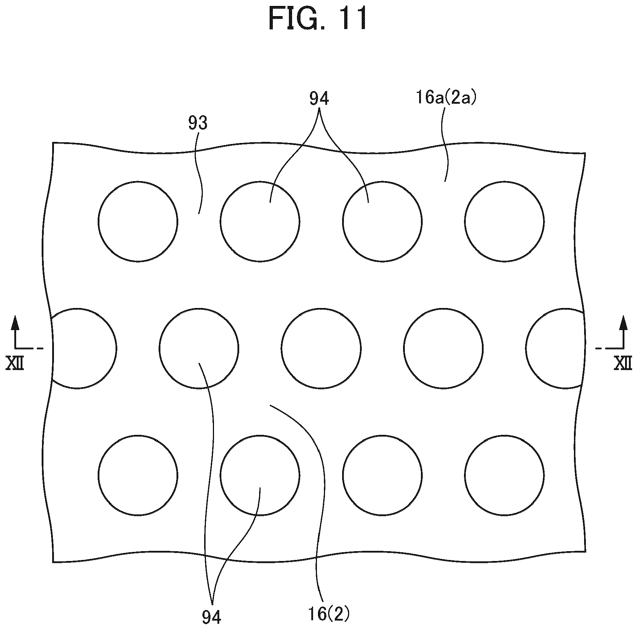

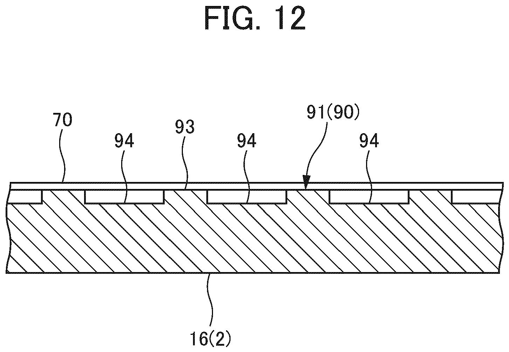

Each of the plurality of protruding portions 93 and recessed portions 94 provided in the label attaching region 90 is not limited to a rectangular shape or a groove shape. For example, as shown in FIGS. 11 and 12, a plurality of recessed portions 94 may be circular and provided in a zigzag pattern, and portions other than the plurality of recessed portions 94 may provide the protruding portions 93. In addition, each of the protruding portions 93 and the recessed portions 94 may include a roughened surface by surface texturing such as emboss processing or satin finishing. In other words, each of the protruding portion 93 and the recessed portion 94 may be a protruding portion and a recessed portion by emboss processing or satin finishing. The surface roughness of such a roughened surface is preferably, for example, an arithmetic average roughness (Ra) of 1.6 or more and 25 or less.

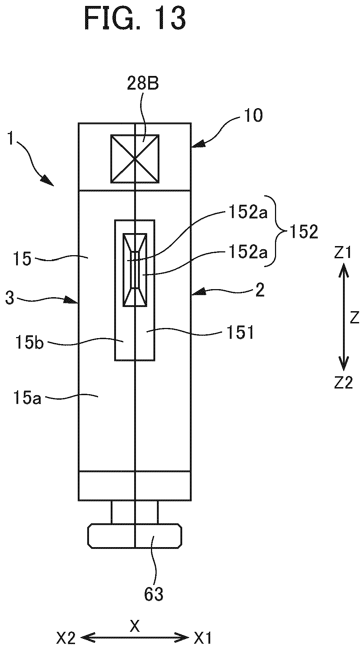

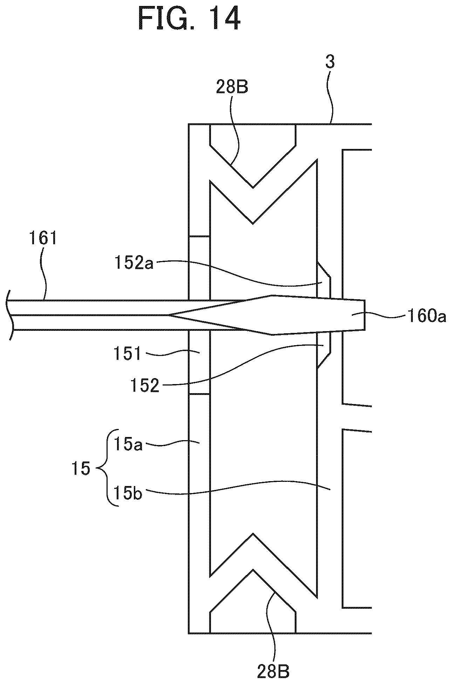

FIGS. 13 and 14 are diagrams each showing a rear end portion of the case 1. FIG. 13 is a rear view of the case 1 as viewed from the rear wall portion 15, and FIG. 14 is a partially enlarged side view showing the rear wall portion 15. As shown in these figures, the outer rear wall portion 15a includes an opening 151 which is a rectangular hole, and the inner rear wall portion 15b includes a groove hole 152 extending in the up-down direction at a portion of the inner rear wall portion 15b in front of the opening 151, for example. The groove hole 152 has a groove shape by the combination of a pair of notches 152a provided in each of the left and right inner rear wall portions 15b, for example. The inner surface of the groove hole 152 has a substantially pyramidal shape extending rearward, for example. The depth of the groove hole 152 is, for example, about half the thickness of the inner rear wall portion 15b, for example.

As shown in FIG. 14, a tip portion 160a of the flathead screwdriver 160 passing through the opening 151 can be fitted into the groove hole 152, for example. When the tip portion 160a of the minus screwdriver 160 fitted in the groove hole 152 is inserted between the first member 2 and the second member 3, and the flathead screwdriver 160 is twisted around the axis or is moved so as to fall to one side in the left-right direction, the joined first member 2 and the second member 3 can be partially separated from each other. The case 1 can be divided into the first member 2 and the second member 3 separately by applying a force to the first member 2 and the second member 3 so that the first member 2 and the second member 3 are separated from each other with the separated portion of the inner rear wall portion 15b as a starting point.

The case 1 according to the embodiments described above includes the case body 10 including the accommodation space 11 that accommodates the plurality of electronic components M and the discharge portion 19 that accommodates and discharges the plurality of electronic components M in and from the accommodation space 11. The label 70 is attachable to the case body 10. The shutter member 30 that is slidably provided to the case body 10 and opens and closes the discharge port 19 by sliding. The case body 10 includes, on at least a portion on the surface 2a thereof, the label attaching region 90 including the plurality of protruding portions 93 to which the attaching surface 70a of the label 70 is attachable. The case 1 according to the embodiments further includes the label 70 attached to at least the label attaching region 90.

With such a configuration, since the entire surface of the attaching surface 70a of the label 70 does not adhere to the label attaching region 90, it is possible to easily detach the label 70 from the case 1. For this reason, when the case 1 is repeatedly used, or when the case 1 is divided into the first member 2 and the second member 3 separately and regenerated for recycling as described above, a situation where the label 70 becomes an obstacle will hardly occur.

In the case 1 according to the embodiments, the label attaching region 90 preferably includes a shape and a size corresponding to the label 70.

With such a configuration, it is possible to attach the label 70 in an orderly manner without protruding from the case 1, and it is also possible for the label 70 to prevent the label attaching region 90 to which stains or the like are likely to adhere due to irregularities from being exposed.

Although the label 70 is attached to the label attaching region 90 so as to cover at least the entire area of the label attaching region 90, a portion of the label 70 may be attached to the surface of the case body 10 other than the label attaching region 90. However, from the viewpoint of easy peeling of the label 70, it is preferable that the area to be attached to the surface of the case body 10 other than the label attaching region 90 is as small as possible.

In the case 1 according to the embodiments, in a surface of the label attaching region 90, the surface area occupied by the entirety of the plurality of protruding portions 93 is larger than the area occupied by the entirety of the plurality of recessed portions 94 or the area other than the area occupied by the plurality of protruding portions 93.

With such a configuration, it is possible to achieve an advantageous effect in that the label 70 can be easily peeled off from the label attaching region 90 while ensuring the attaching force of the label 70 to the label attaching region 90.

In the case 1 according to the embodiments, it is preferable that the groove-shaped depression 100 is provided in the surface 2a of the first member 2 of the case body 10 from the label attaching region 90 over the outside of the label attaching region 90.

When the depression 100 has a width and a depth of which the tip of the finger or the tip of the nail can be inserted, it is possible to lift the edge of the label 70 by using the depression 100 and, therefore, it is possible to easily peel off the label 70 from the case 1 with the edge as a starting point.

In the case 1 according to the embodiments, each of the plurality of protruding portions 93 and the plurality of recessed portions 94 of the label attaching region 90 is a protruding portion or a recessed portion by emboss processing or satin finishing.

With such a configuration, since the entire surface of the attaching surface 70a does not adhere to the label attaching region 90, it is possible to easily detach the label 70 from the case 1. In addition, when the adhesion force of the satin surface provided by the satin finishing or the embossed surface provided by the emboss processing is insufficient, the plurality of protruding portions 93 may be partially increased to obtain a sufficient adhesion force.

In the case 1 according to the embodiments, it is preferable that the label 70 displays information relating to at least one selected from the plurality of electronic components M and the case 1.

This facilitates management of the plurality of electronic components M and the case 1.

Although embodiments have been described above, the present invention is not limited to the embodiments described above, and modifications, improvements, and the like within a scope achieving the object of the present invention are included in the present invention.

### EXPLANATION OF REFERENCE NUMERALS

1 case
2a surface
10 case body
11 accommodation space
19 discharge port (opening)
30 shutter member
70 label
70a attaching surface
90 label attaching region
93 protruding portion
94 recessed portion
100 depression
M electronic component (component)

## Claims

1. A case comprising:
a case body including an accommodation space that accommodates a plurality of components and an opening that accommodates in and discharges the plurality of components and from the accommodation space, wherein a label is attachable to the case body; and
a shutter member that is slidably provided to the case body and opens and closes the opening by sliding,
wherein the case body includes, on at least a portion on a surface thereof, a label attaching region including a plurality of protruding portions to which an attaching surface of the label is attachable.

2. The case according to claim 1, wherein the label attaching region further includes a plurality of recessed portions spaced apart from the attaching surface of the label.

3. The case according to claim 1 or 2, further comprising the label attached to at least the label attaching region.

4. The case according to claim 3, wherein the label attaching region has a shape and size corresponding to the label.

5. The case according to claim 2, wherein, in a surface of the label attaching region, surface area occupied by an entirety of the plurality of protruding portions is larger than area occupied by an entirety of the plurality of recessed portions or area other than the area occupied by the plurality of protruding portions.

6. The case according to any one of claims 1 to 5, wherein a groove-shaped depression is provided from the label attaching region over an outer side of the label attaching region.

7. The case according to claim 2, wherein each of the plurality of protruding portions and the plurality of recessed portions is a protruding portion or a recessed portion by emboss processing or satin finishing.

8. The case according to claim 3, wherein the label displays information relating to at least one selected from the plurality of components and the case.
